# EUROPEAN PATENT SPECIFICATION

(11) **EP 4 056 730 B1**
(45) Date of publication and mention of the grant of the patent: **17.07.2024**
(21) Application number: 21161744.4
(22) Date of filing: 10.03.2021
(51) Int. Cl.: C23C 16/448, C30B 25/14, C30B 35/00, F17C 11/00, B01B 1/00, B01D 1/00

(54) **CONTAINER FOR FEEDING A PRECURSOR MATERIAL**
BEHÄLTER ZUM ZUFÜHREN EINES VORLÄUFERMATERIALS
RÉCIPIENT POUR L'ALIMENTATION D'UN MATÉRIAU PRÉCURSEUR

(43) Date of publication of application: 14.09.2022
(73) Proprietor: SK Inc., Jongro-gu, Seoul (KR)
(72) Inventor: VERVOORT, Paul, 2200 Herentals (BE)
(74) Representative: Zacco Sweden AB

(56) References cited:
- WO-A1-2019/101653
- WO-A2-2010/053878
- JP-A- 2010 040 695
- US-A1- 2009 181 168
- US-B1- 6 270 839
- ONOE A ET AL: "Anomalous evaporation characteristics of vitrificated K(DPM) and stable gas supply using disk-shaped K(DPM) precursors for metalorganic chemical vapor deposition", JOURNAL OF CRYSTAL GROWTH, ELSEVIER, AMSTERDAM, NL, vol. 277, no. 1-4, 15 April 2005 (2005-04-15), pages 546 - 554, XP027850399, ISSN: 0022-0248, [retrieved on 20050415]

## Description

### Technical field

The present invention relates to a precursor vapor delivery device for a coating apparatus such as a (plasma enhanced) chemical vapor phase deposition apparatus, (plasma enhanced) atomic layer deposition apparatus, apparatus for epitaxial layer growth, or the like. The present invention further relates to the construction of such a container to create a well-defined gas flow with a given concentration on vaporized precursor material.

### Technical background

Coating processes where a coating material is deposited onto a surface are well known in the art. In a so-called Chemical Vapor Deposition, Atomic Layer Deposition or epitaxial growth, a substrate is exposed to one or more volatile precursors, which produce a desired thin film deposit on a substrate by chemically reacting with a co-reactant present in the deposition chamber.

In a Chemical Vapor Deposition process or an Atomic Layer Deposition process, a precursor material, such as MoO₂Cl₂ is used. The precursor material may be a solid powder and/or granule-like material which is provided in suitable containers. The containers comprise an inlet and an outlet to connect the container to a processing system. A carrier gas can be fed through the container and if required at an increased temperature to vaporize the solid precursor material by sublimation. The carrier gas is enriched by the vaporized precursor material to provide a continuous gas flow with a predefined concentration of the precursor material.

As known from document US 6,270,839 B1, a raw material feeding apparatus for feeding a gas sublimated from a solid raw material to a film-forming apparatus using chemical vapor phase deposition is known. The apparatus comprises sub-containers each having an inlet opening for introducing a gas into each of the sub-containers, an outlet opening for discharging the gas, a bottom on which the solid raw material is spread between the inlet and the outlet openings, and a wall for defining a gap in conjunction with the bottom in which the introduced gas is moved on the surface of the solid raw materials spread on the bottom while contacting the solid raw material. The device further comprises a raw material container for accommodating and holding the sub-containers, a heating device for heating the raw material container, and a device for introducing a carrier gas into the raw material container.

Document US 10,465,286 B2 discloses a vapor delivery vessel for vaporizing and delivering vaporized source material comprising a peripheral vessel wall bounding an interior volume, a gas inlet being adapted to supply gas to the interior volume and a gas outlet arranged in at least intermittent fluid communication with the interior volume. Furthermore, the vessel comprises a plurality of support surfaces defined by a plurality of holders, a porous steel material provided in a flow path extending between the gas inlet and the gas outlet and positioned over a top holder of the plurality of holders. By means of a lid, the porous steel material is pressed over the top holder.

A process with a vaporized materials and/or its reactor is also demonstrated in Onoe A et al., "anomalous evaporation characteristics of vitrificated K (DPM) and stable gas supply using disk-shaped K (DPM) precursors for metalorganic chemical vapor deposition", Journal of Crystal Growth, vol. 277, no. 1-4, pp. 546-554, 2005; US 2009/181168 A1; WO 2019/101653 A1; WO 2010/053878 A2 and JP 2010 040695 A.

However, the proposed solutions do not provide an even discharge of the precursor material from the material supply. Furthermore, conventional containers do not provide a reasonable rate of emptying the container under stable gas discharge conditions.

It is, therefore, an object of the present invention to provide a precursor material container which provides a high degree of discharge capability under a stable material concentration of the discharged vaporized precursor material.

### Summary of the invention

This object has been resolved by the container for vaporizing a precursor material and delivering the vaporized precursor material according to claim 1 and a method for operating the container according to the further independent claim.

Further embodiments are indicated in the depending subclaims.

The container for vaporizing a precursor material and delivering the vaporized precursor material comprises:
- a receiving part bounding an inner volume;
- a number ofsubcarrier trays arranged on top of each other within the inner volume;
- each subcarrier tray forming a gas flow channel, at least one of the subcarrier trays comprising:
   ∘ a subcarrier holder configured to store the precursor material, and
   ∘ a holder lid configured to seal the subcarrier holder wherein the holder lid is provided with one or more fins protruding from the lower side of the holder lid towards the subcarrier holder into the precursor material surface to form an unbranched gas flow channel covering between a first tray port (46) and a second tray port (47) covering at least 90% of the surface of the precursor material in the subcarrier tray (4).
   ∘ the holder lid (42) is configured to at least partly form a lid sidewall (50) of the subcarrier tray (4) which abuts to the inner wall of the cylindrical volume of the container (1), thereby encompassing a portion of the sidewall of the subcarrier holder (41), wherein the lid sidewall (50) substantially perpendicularly protruding from a main lid surface S towards the subcarrier holder (41), wherein a shape and extension of the lid sidewall (50) of the holder lid (42) and of the sidewall (45) of the subcarrier holder (41) are configured to form a further gas flow channel (G) together with a portion of the wall of the inner volume.

Bubbler-type containers for solid precursor materials usually have the issue that the evaporation of the solid precursor material may be unstable and/or that the amount of evaporation is relatively low. With a powder/granule precursor material, only the top surface of the material and preferential gas channels formed in the material show a good surface refreshment. Thus, only main gas paths which develop during operation contribute to the vaporization of the precursor material while other areas of the material are not substantially covered by the carrier gas stream so that less material can be evaporated therefrom. Therefore, only parts of the surface of the precursor material effectively contribute to enrich the carrier gas with the vaporized precursor material so that the surface of the material gets more and more uneven which negatively affects the discharging process even more. Moreover, to the end of the discharging process of the container, precursor material remains unused not interfering with the main flow path of the carrier gas.

Furthermore, the precursor material needs to be heated to increase the vaporization rate, however, particularly in case of a powder/granule material type of precursor, heating up the material homogeneously is considerably more difficult than heating a liquid material.

According to above container, one or more sub-carrier trays are arranged having a material holder for holding the solid precursor material covered by a lid which has a fin structure protruding from the lower side of the lid (towards the interior of the material holder) into the precursor material stored in or on the material holder. Between the lower surface of the lid and the surface of the material, the fins define a gas flow path substantially covering the material surface. The gas flow channel is unbranched and the flow path has a dimension which does not allow to form branched gas flow paths within the sub-carrier tray.

To achieve a high discharge rate, the fins protrude to the bottom of the material holder to form almost closed channels for the gas stream, thereby allowing a full discharge of the precursor material from the container.

Furthermore, the fins may be arranged to form a spiral gas flow channel between a first tray port in a sidewall of the subcarrier holder and a second tray port in the holder lid, particularly at the center of the holder lid.

Alternatively, the fins may be arranged to form a meandric gas flow channel between a first tray port in a sidewall of the subcarrier holder and a second tray port in the holder lid or at another portion of the sidewall of the subcarrier holder.

It may be provided that the fins are configured to form a gas flow channel between a first tray port and a second tray port wherein the gas flow channel at least covers 90% of the surface of the subcarrier tray.

It may be provided that the one or more fins protrude substantially to the bottom of the subcarrier holder.

Moreover, the subcarrier holder is filled with a precursor material so that the holder lid, the surface of the precursor material and the one or more fins form the gas flow channel through the subcarrier tray.

The subcarrier trays is configured to force the carrier gas flow through the container to pass through the gas flow channels in each of the subcarrier trays.

Moreover, the holder lid has a sidewall which encompasses the subcarrier holder and which extends along a part of the circumference which partly abuts the wall of the inner volume, wherein the subcarrier holder is configured to have a sidewall, wherein a shape and extension of the sidewall of the holder lid and of the sidewall of the subcarrier holder are configured to form a further gas flow channel together with a portion of the wall of the inner volume. Between the sidewall of the holder lid and of the sidewall of the subcarrier holder a spring element may be included to allow the sidewalls to abut at the wall of the inner volume with a force to improve heat transfer onto the subcarrier holder and the holder lid.

A distancing structure may be provided at the bottom of the subcarrier trays to allow a carrier gas flow along the bottom of the respective subcarrier trays from/to a portion of an inner wall of the receiving part of the container.

According to an embodiment, the gas flow channel formed in the at least one subcarrier tray may be configured to have a Reynolds number of less than 2000 preferably less than 5000.

Each subcarrier holder may be filled with a bulk precursor material, such as a powder-like or granule-like material.

Furthermore, a heating element may be attached to the container to heat the container up to at least an evaporation temperature of the precursor material.

According to a further aspect, a method for delivering a vaporized precursor material is provided, comprising:
- Providing the above container including precursor material;
- Supplying a carrier gas to the container;
- Receiving the carrier gas enriched with the vaporized precursor material.

According to a further aspect, a product produced by a vaporized precursor material delivered according to above method.

According to yet another aspect, a method for delivering a vaporized precursor material is provided, comprising:
- Providing the above container including precursor material;
- Receiving the vaporized precursor material.

In this method operation is carried out without carrier gas, but merely vapor draw function.

According to yet another aspect, a product produced by a vaporized precursor material delivered according to above method.

### Brief description of the drawings

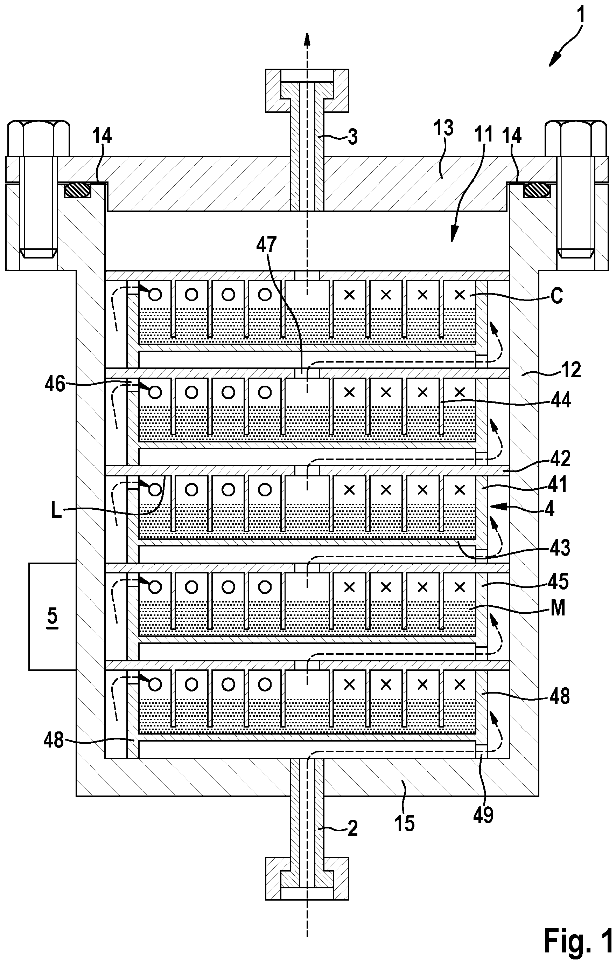

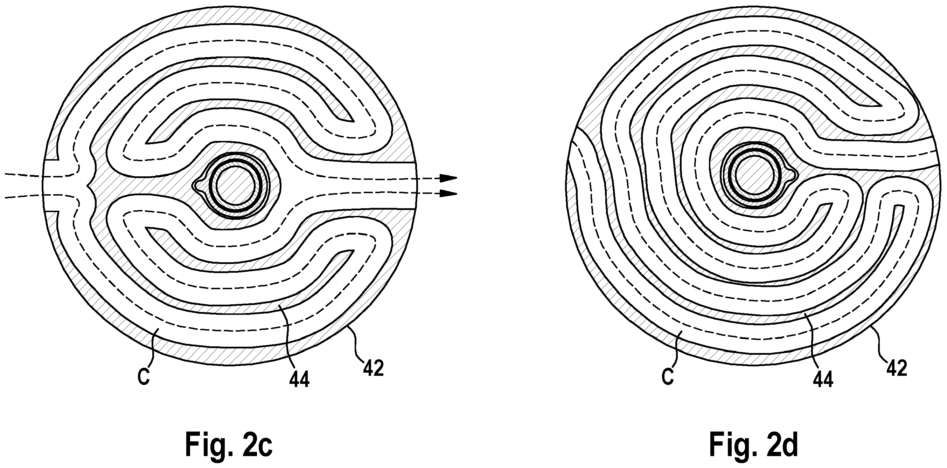

Embodiments are described in more detail in conjunction with the accompanying drawings, in which Figure 1 and Figure 2c are not according to the invention and are present for illustration purposes only:
Figure 1 shows a cross-sectional view through a container for vaporizing a solid precursor material.
Figures 2a to 2d show top views onto the lower surface of the lids defining the gas flow channels within the subcarrier trays.
Figure 3 shows a cross-sectional view through a embodiment of a container for vaporizing a solid precursor material.
Figures 4a and 4b show a perspective view and a side view onto one subcarrier tray as used in the container of Figure 3.
Figure 5 shows a bottom plane of the container having an elevated structure.
Figure 6 shows a more detailed cross-sectional view through one subcarrier tray with a spring element between the subcarrier and the holder lid.

### Description of embodiments

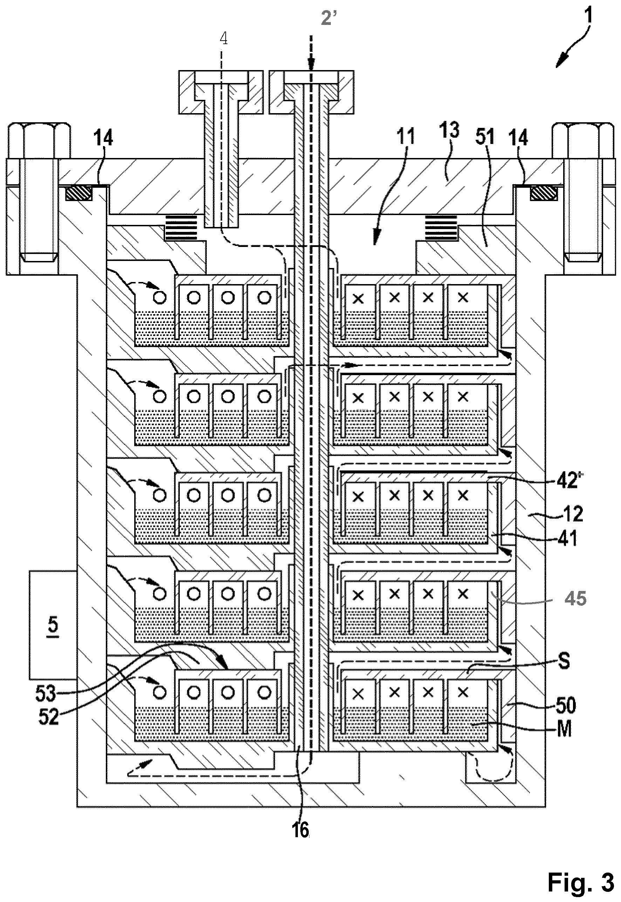

Figure 3 shows a cross-sectional view through a substantially cylindrical container 1 for storing a solid precursor material to be used for a chemical vapor deposition process, atomic layer deposition, or epitaxial growth. The solid material can be any type of precursor material to react and/or decompose in a chemical vapor deposition process to apply a thin film onto a surface of a substrate. For instance, the precursor material may comprise MoO₂Cl₂, WCI5, TMI or the like.

The precursor material may be a powder, sintered powder or granulate or any other kind of form factor, such as small balls or the like, which enables high volume industrial handling of the precursor material (free flowing properties, less dust generation, ...).

In the present embodiment, the container 1 has a volume 11 and a cup-shaped receiving part 12 which is closed by a container lid 13. A gasket 14 can be provided to ensure a secure sealing of the cylindrical volume 11. A first gas port 2' is arranged on the container lid 13 acting as a carrier gas inlet. The gas inlet 2' is connected with an inlet gas guide 16, such as a tube, passing through respective through-openings of the subcarrier trays 4 to the bottom of the container 1, i.e. to a region below the lowest subcarrier tray 4. Particularly, the subcarrier holders 41 are provided with a central through-opening to accommodate the inlet gas guide 16 by keeping a gap between the outer wall of the inlet gas guide 16 and the inner walls of the through-opening as small as possible to prevent/minimize a gas stream through the gap between the through-opening and the inlet gas guide 16. The through-opening through the subcarrier holder are formed by inner sidewalls which form a tube shape.

Within the receiving part 12, a number of substantially identical subcarrier trays 4 is arranged on each other. Each of the subcarrier trays 4 has a subcarrier holder 41 and a plain bottom 43. Particularly, the subcarrier holders 41 are provided with a central through-opening to accommodate the inlet gas guide 16 by keeping a gap between the outer wall of the inlet gas guide 16 and the inner walls of the through-opening as small as possible to prevent/minimize a gas stream through the gap between the through-opening and the inlet gas guide 16. The through-opening through the subcarrier holder are formed by inner sidewalls which form a tube shape.

Onto the subcarrier holders 41, a holder lid 42 is configured to at least partly form a lid sidewall 50 of the subcarrier tray 4 which abuts to the inner wall of the cylindrical volume of the container 1, thereby encompassing a portion of the sidewall of the subcarrier holder 41. The lid sidewall 50 substantially perpendicularly protrudes from a main lid surface S towards the subcarrier holder 41. In the interior of the subcarrier holder 41, the bottom 43 is covered with a precursor material M to be vaporized. The vaporized precursor material M enriches the carrier gas wherein the enriched carrier gas is carried out of the container 1.From the holder lid 42 into the interior of the subcarrier tray 4, one or more channel-forming fins 44 are provided which form a gas flow channel through the interior of the inner volume of the subcarrier tray 4 along the surface of the precursor material M stored therein. The fins 44 protrude substantially perpendicular from a lower surface L of the holder lid 42 towards the bottom 43 of the subcarrier holder 41. As the subcarrier holder 41 is closed by the holder lid 42 after the precursor material has been filled in, the fins 44 protrude from the holder lid 42 with a length so that the remote ends of the fins 44 has only a slight distance to the bottom 43 of the subcarrier holder 41 such as between 0.5 and 2 mm. This allows easy placement of the holder lid 42 onto the subcarrier holder 41 when it is filled with the solid precursor material M since material between the bottom 43 and the remote ends of the fins 44 do not prevent the closing of the subcarrier tray 4.

Each subcarrier tray 4 has a first tray port 46 at the sidewall 45 of the subcarrier tray 4 close to the open end of the subcarrier holder 41 which has been covered by the holder lid 42. The first tray port 46 allows carrier gas to enter the interior of the respective subcarrier tray 4 into the gas flow channel defined by the fins 44. The arrangement of the first tray port 46 close to the holder lid 42 allows the gas flow into the interior of the subcarrier tray 4 not to be blocked by the stored precursor material M.

From the first tray port 46 at the sidewall 45 of the subcarrier tray 4, the carrier gas is fed through the gas flow channel formed by the fins 44 within the subcarrier tray 4 to a second tray port 47 arranged in the holder lid 42. Through the second tray port 47 the enriched carrier gas is supplied to the next subcarrier tray 4 located on top.

For guiding the carrier gas flow, the holder lids 42 of each subcarrier tray 4 have a shape which fits the inner cross-sectional shape of the receiving part 12, thereby blocking carrier gas form circumventing flowing through the respective subcarrier tray 4 and sealing the subcarrier trays 4 from each other. In this way, the carrier gas flow is forced to pass through the second tray port 47 to the next subcarrier tray 4 on top, if any.

The bottom side of the subcarrier holder 41 has a support structure 52 for being supported by a surface 53 of the holder lid 42 of a subcarrier tray 4 arranged below. The support structure 52 is arranged to allow a gas flow from the second tray port 47, wherever is located in the upper side of the holder lid 42 to the edge portion where the inlet opening of the gas flow channel C along the sidewall of the container 1 is provided.

The subcarrier trays 4 have a distancing structure 48 which allows a flow channel to be formed between the outer surface of the bottom 43 of the subcarrier holder 4 and the area it is placed on such as the bottom 15 of the container or the upper surface of the holder lid 42 of the subcarrier tray 4 arranged directly below.

In the distancing structure 48 or at the sidewall of the distancing structure 48, an opening 49 is provided to allow the flow of the carrier gas from the area under the subcarrier tray 4 to the inner sidewall of the container 1. The distancing structure 48 can be an integral part of the subcarrier holder 41 but can also be formed onto the outer surface of the holder lid 42 or as a separate part.

The container 1 wall may be heated to support the heating of the carrier gas and so the precursor material M to improve vaporization. For heating a heating element 5 can be arranged at the receiving part 12 of the container 1. The gas flow for each subcarrier tray 4 is thereby formed by the distancing structure 48 guiding the carrier gas to the inner wall of the receiving part 12 of the container 1 to the first tray port 46 of the subcarrier holder 41 and to the interior of the subcarrier tray 4.

Substantially, the opening in the distancing structure 48 and the opening in the sidewall of the subcarrier holder 41 may be arranged on opposite sides with respect to the cross-sectional shape of the subcarrier tray 4. Thereby, the carrier gas flow is forced to circumvent the subcarrier tray 4, thereby receiving heat applied to the container 1 so that the precursor material M within the subcarrier trays 4 is not only heated by heat conduction and radiation, but also by convection.

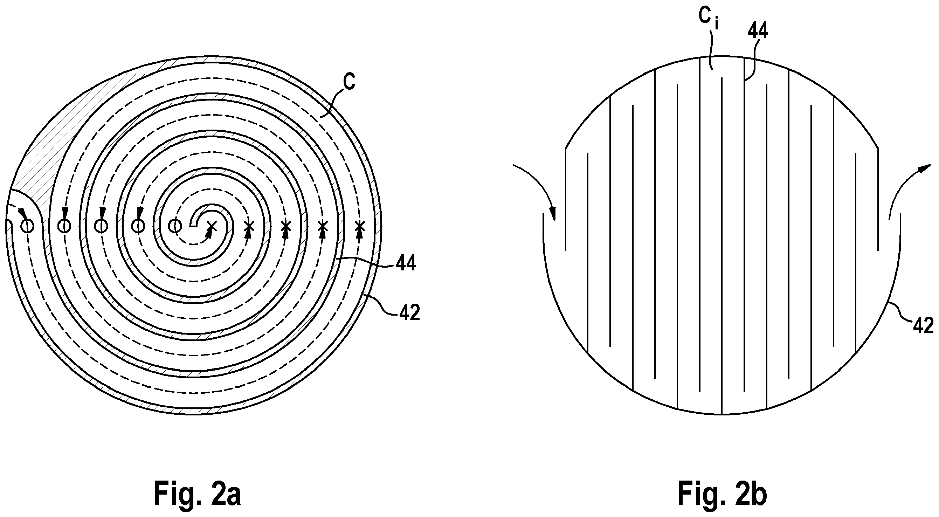

The fins 44 are used to form a gas flow channel C through each of the subcarrier trays 4, for example, to form a spiral gas channel as shown in the top view onto the lower side of the holder lid 42 in Figure 2a. Furthermore, as the second tray port 47 does not need to be in the center of the holder lid 42, a meandric structure through the interior of the subcarrier tray 4 can be provided by the form of the fins 44 as e.g. shown in Figure 2b. Here the fins 44 have a longitudinal shape arranged in a comb-like manner to form a gas flow channel covering the whole area of the subcarrier holder 41. Other possibility to arrange the fins 44 in a way to form a gas flow channel C is shown in Figure 2d. Basically, each arrangement of the fins is preferred which creates a gas flow channel C which covers the full surface of the precursor material in the subcarrier tray, particularly more than 90% of the surface.

The channel size is selected to provide an at least close to laminar gas flow the channels as thereby is avoided the occurrence of surface regions on the precursor material M which are not covered by the carrier gas flow or only effected by a reduced carrier gas flow. Particularly, the gas channels may be formed with a Reynolds value of less than 2000, particularly less than 5000.

The fins may be designed to have a thickness of around 2 mm or in the range of 0.5 mm to 5 mm or in the range of 5 mm to 20 mm. The height of the fins is related to the tray depth. To avoid blocking the assembly the fin height may be e.g. smaller by about 0,5 - 2 mm than the tray depth in which the precursor material is kept.

It is preferred to only form a single carrier gas flow channel to avoid splitting the gas flow into two unequal gas streams which will become even more unequal over time due to an uneven vaporization of the precursor material M. The width and the cross-sectional area of the gas flow channel C is kept small to avoid an inhomogeneous flow distribution. Substantially, the cross-sectional area of the gas flow channels C formed by the fins 44 is equal or higher than the cross-section of the first gas port 2 or the second gas port 3 of the container 1.

The fins 44 enable that the refreshment of the precursor material top surface remains intact during consumption of the solid precursor material so that the precursor material height drops equally along the carrier gas flow stream. Attaching the fins 44 on the holder lid 42 has the advantage that no complicated sealings need to be constructed at the holder lid 42 which would be required if the fins were protruding from the bottom of the subcarrier holder upwardly. In the invention, the bottom sealing between the remote ends of the fins 44 and the subcarrier holder 41 is achieved by the precursor material M itself. The attachment of the fins 44 at the holder lid 42 also prevent the precursor material M from displacement during transportation as no spillovers over the fins 44 may occur.

Furthermore, the holder lid 42 is configured to at least partly form a lid sidewall 50 of the subcarrier tray 4 which abuts to the inner wall of the cylindrical volume of the container 1, thereby encompassing a portion of the sidewall of the subcarrier holder 42. The lid sidewall 50 substantially perpendicularly protrudes from a main lid surface S towards the subcarrier holder 41.

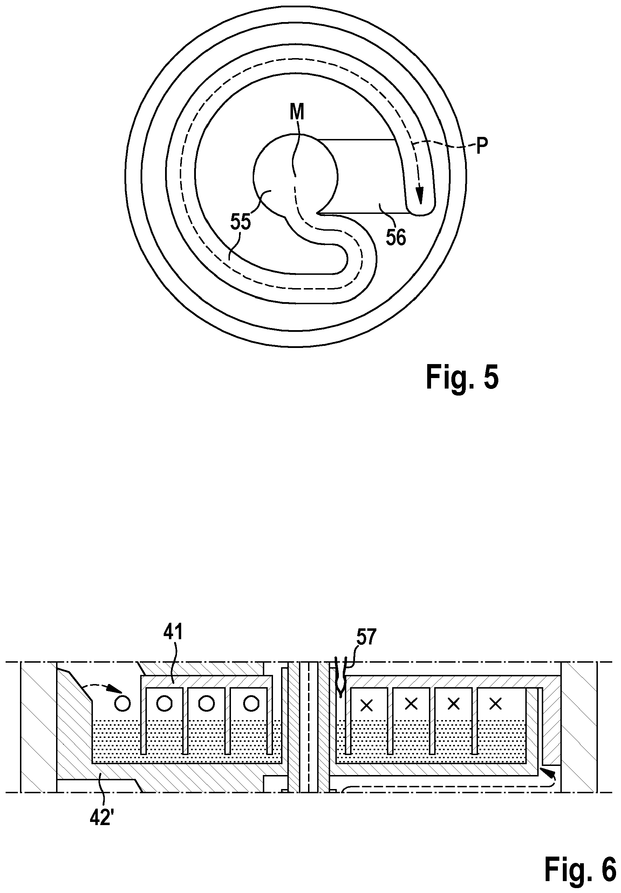

As shown in more detail in Figure 6 a radial force is applied between the subcarrier holder 41 and the holder lid 42. Therefore, between the inner sidewall of the holder lid 42 and of the sidewall of the subcarrier holder 41 a spring element 57 may be inserted to allow the outer sidewalls of the holder lid 42 to be pressed/ abut at the wall of the inner volume with a force to improve heat transfer onto the subcarrier holder 41 and the holder lid 42. The spring element 57 may be formed as a leg spring.

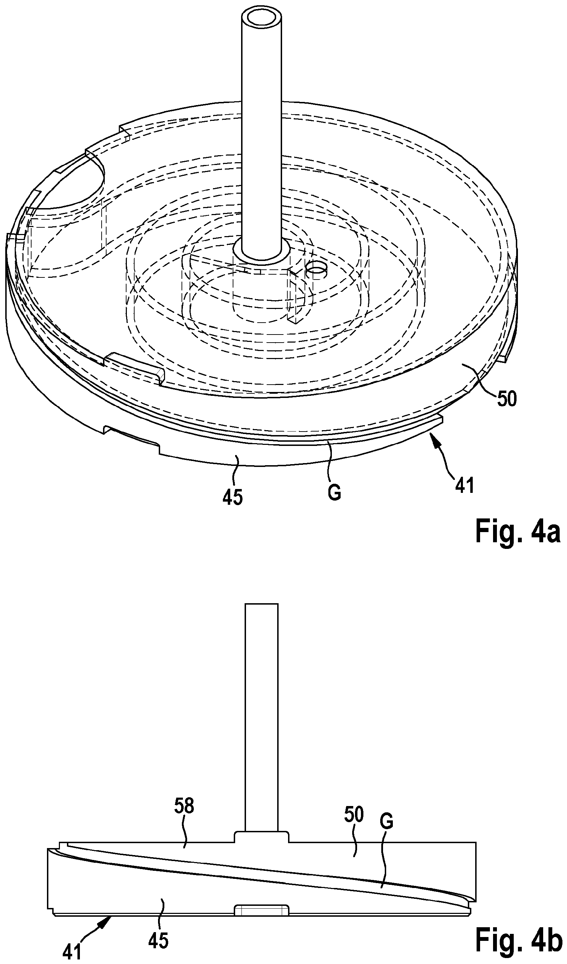

As shown in the perspective view and side view of Figures 4a and 4b, respectively, a gas flow guidance G is formed between the lid sidewall 50 of the holder lid 42 and the sidewall 45 of the subcarrier tray in an inclined manner so that the gas flow guidance G forms a flow path from an edge position at the bottom of each subcarrier tray 4 along the inner sidewall of the cylindrical volume 11 and to a position at a top of the subcarrier holder at another circumferential position preferably on the opposite side of the subcarrier tray 4. The sidewall 45 of the subcarrier tray 4 has an inclined structure along its circumferential direction which defines together with the sidewall 50 of the holder lid 42 the gas flow channel C. The extension of the gas flow channel C is configured to receive gas from an edge portion of the bottom of each subcarrier tray 4 and guides the gas to another circumferential position at the top portion of each subcarrier tray 4 thereby enabling the gas to be heated by flowing along the inner sidewall of the container 1.

Figure 5 shows a bottom plane of the container 1 having a recessed structure 55 and an elevated structure 56 forming a gas flow channel P from a center portion M to an edge portion corresponding to the lower opening of the gas flow channel C in the sidewall of the lowest subcarrier tray 4. The elevated structure 56 at the bottom serves to support the lowest subcarrier tray 4 to ensure a stable and orientation in parallel to the radial direction of the cylindrical volume 11 of the container 1.

Moreover, between the container lid 13 and the holder lid 42 of the upmost subcarrier tray 4 a pressing structure 51 is arranged which ensures that, when the container is closed, a force is permanently applied onto the stack of subcarrier trays 4 to ensure a stable arrangement of the subcarrier trays in the container 1.

### Reference signs

- 1: container
- 11: cylindrical volume
- 12: receiving part
- 13: container lid
- 15: bottom of the receiving part
- 2: first gas port
- 3: second gas port
- 4: subcarrier trays
- 41: subcarrier holder
- 42: holder lid
- 43: bottom
- 44: fins
- 45: sidewall of the subcarrier holder
- 46: first tray port
- 47: second tray port
- 48: distancing structure
- 49: opening
- 50: lid sidewall
- 51: pressing structure
- 52: support structure
- 53: surface
- 55: recessed structure
- 56: elevated structure
- 57: spring element
- 5: heating element
- M: precursor material
- C: channel

## Claims

1. Container (1) for vaporizing a precursor material and delivering the vaporized precursor material, comprising:
- a receiving part (12) bounding an inner volume; and
- a number of subcarrier trays (4) arranged on top of each other within the inner volume,
- wherein each subcarrier tray (4) forms a gas flow channel, wherein at least one of the subcarrier trays (4) comprises
∘ a subcarrier holder (41) configured to store the precursor material, and
∘ a holder lid (42) configured to seal the subcarrier holder (41) wherein the holder lid (42) is provided with one or more fins (44) protruding from the lower side of the holder lid (42) towards the subcarrier holder (41) into the precursor material surface to form an unbranched gas flow channel (C) between a first tray port (46) and a second tray port (47) covering at least 90% of the surface of the precursor material in the subcarrier tray (4), and
∘ the holder lid (42) is configured to at least partly form a lid sidewall (50) of the subcarrier tray (4) which abuts to the inner wall of the cylindrical volume of the container (1), thereby encompassing a portion of the sidewall (45) of the subcarrier holder (41), wherein the lid sidewall (50) perpendicularly protrudes from a main lid surface S towards the subcarrier,
wherein a shape and extension of the lid sidewall (50) of the holder lid (42) and of the sidewall (45) of the subcarrier holder (41) are configured to form a further gas flow channel (G) together with a portion of the wall of the inner volume.

2. Container (1) according to claim 1, wherein the fins (44) are arranged to form a spiral gas flow channel (C) between the first tray port (46) in a sidewall (45) of the subcarrier holder (41) and the second tray port (47) in the holder lid (42).

3. Container (1) according to claim 1, wherein the fins (44) are arranged to form a meandric gas flow channel (C) between the first tray port (46) in a sidewall (45) of the subcarrier holder (41) and the second tray port (47) in the holder lid (42) or at another portion of the sidewall (45) of the subcarrier holder (41).

4. Container (1) according to any of the claims 1 to 3, wherein the gas flow channel (C) is blocked from circumventing flowing through the respective subcarrier tray (4) to pass through the second tray port (47) to the next subcarrier tray (4) on top.

5. Container (1) according to any of the claims 1 to 4, wherein the gas flow channel (C) in each of the subcarrier trays (4) is formed for the carrier gas to flow through the container (1).

6. Container (1) according to any of the claims 1 to 5, wherein a distancing structure (48) is provided at the bottom of the subcarrier trays (4) to allow a carrier gas flow along the bottom of the respective subcarrier trays (4) from/to a portion of an inner wall of the receiving part (12) of the container (1).

7. Container (1) according to any of the claims 1 to 6, wherein a heating element (5) is attached to the container (1) to heat up the container (1) to at least an evaporation temperature of the precursor material.

8. A method for delivering a vaporized precursor material, wherein the method is comprised of
- providing a container (1) according to any of the claims 1 to 7 with precursor material;
- supplying a carrier gas to the container and
- receiving the carrier gas enriched with the vaporized precursor material or the vaporized precursor material by vapor draw.

9. A method for delivering a vaporized precursor material of claim 8, wherein the carrier gas flows along the gas flow channel (C) with a Reynolds number of less than 2000 preferably less than 5000.

10. A method for delivering a vaporized precursor material of claim 8 or 9, wherein the precursor material filled in the subcarrier holder (41) is a bulk type, such as a powder-like, sintered powder or granule like material.

## Patentansprüche

1. Behälter (1) zum Verdampfen eines Präkursormaterials und Abgeben des verdampften Präkursormaterials, umfassend:
- einen Aufnahmeteil (12), der ein Innenvolumen begrenzt; und
- eine Anzahl von Unterträgerwannen (4), die übereinander innerhalb des Innenvolumens angeordnet sind,
- wobei jede Unterträgerwanne (4) einen Gasströmungskanal bildet, wobei mindestens eine der Unterträgerwannen (4) umfasst
o einen Unterträgerhalter (41), der konfiguriert ist, um das Präkursormaterial zu lagern, und
o einen Halterdeckel (42), der konfiguriert ist, um den Unterträgerhalter (41) abzudichten, wobei der Halterdeckel (42) mit einer oder mehreren Rippen (44) versehen ist, die von der Unterseite des Halterdeckels (42) in Richtung des Unterträgerhalters (41) in die Präkursormaterialoberfläche vorstehen, um einen unverzweigten Gasströmungskanal (C) zwischen einer ersten Wannenöffnung (46) und einer zweiten Wannenöffnung (47) zu bilden, der mindestens 90 % der Oberfläche des Präkursormaterials in der Unterträgerwanne (4) bedeckt, und
oder Halterdeckel (42) konfiguriert ist, um mindestens teilweise eine Deckelseitenwand (50) der Unterträgerwanne (4) zu bilden, die an der Innenwand des zylindrischen Volumens des Behälters (1) anliegt, wodurch ein Abschnitt der Seitenwand (45) des Unterträgerhalters (41) umschlossen wird, wobei die Deckelseitenwand (50) senkrecht von einer Deckelhauptoberfläche S in Richtung des Unterträgers vorsteht,
wobei eine Form und Verlängerung der Deckelseitenwand (50) des Halterdeckels (42) und der Seitenwand (45) des Unterträgerhalters (41) konfiguriert sind, um einen weiteren Gasströmungskanal (G) zusammen mit einem Abschnitt der Wand des Innenvolumens zu bilden.

2. Behälter (1) gemäß Anspruch 1, wobei die Rippen (44) angeordnet sind, um einen spiralförmigen Gasströmungskanal (C) zwischen der ersten Wannenöffnung (46) in einer Seitenwand (45) des Unterträgerhalters (41) und der zweiten Wannenöffnung (47) im Halterdeckel (42) zu bilden.

3. Behälter (1) gemäß Anspruch 1, wobei die Rippen (44) angeordnet sind, um einen mechanischen Gasströmungskanal (C) zwischen der ersten Wannenöffnung (46) in einer Seitenwand (45) des Unterträgerhalters (41) und der zweiten Wannenöffnung (47) im Halterdeckel (42) oder an einem anderen Abschnitt der Seitenwand (45) des Unterträgerhalters (41) zu bilden.

4. Behälter (1) gemäß einem der Ansprüche 1 bis 3, wobei der Gasströmungskanal (C) daran gehindert wird, das Strömen durch die jeweilige Unterträgerwanne (4) zu umgehen, um durch die zweite Wannenöffnung (47) zur nächsten Unterträgerwanne (4) oben zu gelangen.

5. Behälter (1) gemäß einem der Ansprüche 1 bis 4, wobei der Gasströmungskanal (C) in jeder der Unterträgerwannen (4) gebildet ist, damit das Trägergas durch den Behälter (1) strömt.

6. Behälter (1) gemäß einem der Ansprüche 1 bis 5, wobei eine Abstandsstruktur (48) am Boden der Unterträgerwannen (4) bereitgestellt ist, um eine Trägergasströmung entlang des Bodens der jeweiligen Unterträgerwannen (4) von/zu einem Abschnitt einer Innenwand des Aufnahmeteils (12) des Behälters (1) zu ermöglichen.

7. Behälter (1) gemäß einem der Ansprüche 1 bis 6, wobei ein Heizelement (5) an dem Behälter (1) angebracht ist, um den Behälter (1) auf mindestens eine Verdampfungstemperatur des Präkursormaterials aufzuheizen.

8. Verfahren zum Abgeben eines verdampften Präkursormaterials, wobei das Verfahren umfasst
- Bereitstellen eines Behälters (1) gemäß einem der Ansprüche 1 bis 7 mit Präkursormaterial;
- Zuführen eines Trägergases zu dem Behälter und
- Aufnehmen des mit dem verdampften Präkursormaterial angereicherten Trägergases oder des verdampften Präkursormaterials durch Dampfzug.

9. Verfahren zum Abgeben eines verdampften Präkursormaterials gemäß Anspruch 8, wobei das Trägergas entlang des Gasströmungskanals (C) mit einer Reynolds-Zahl von weniger als 2000, vorzugsweise weniger als 5000, strömt.

10. Verfahren zum Abgeben eines verdampften Präkursormaterials gemäß Anspruch 8 oder 9, wobei das in den Unterträgerhalter (41) gefüllte Präkursormaterial ein Schüttguttyp ist, wie beispielsweise ein pulverartiges, gesintertes Pulver oder granulatartiges Material.

## Revendications

1. Récipient (1) pour vaporiser un matériau précurseur et délivrer le matériau précurseur vaporisé, comprenant :
- une partie réceptrice (12) délimitant un volume interne ; et
- un certain nombre de plateaux sous-porteurs (4) agencés les uns sur les autres à l'intérieur du volume interne,
- dans lequel chaque plateau sous-porteur (4) forme un canal d'écoulement de gaz, dans lequel au moins l'un des plateaux sous-porteurs (4) comprend
o un support sous-porteur (41) configuré pour stocker le matériau précurseur, et
o un couvercle de support (42) configuré pour sceller le support sous-porteur (41), dans lequel le couvercle de support (42) est pourvu d'une ou plusieurs ailettes (44) faisant saillie depuis le côté inférieur du couvercle de support (42) vers le support sous-porteur (41) dans la surface du matériau précurseur pour former un canal d'écoulement de gaz non ramifié (C) entre un premier orifice de plateau (46) et un second orifice de plateau (47) couvrant au moins 90 % de la surface du matériau précurseur dans le plateau sous-porteur (4), et
o le couvercle de support (42) est configuré pour former au moins en partie une paroi latérale de couvercle (50) du plateau sous-porteur (4) qui vient en butée contre la paroi interne du volume cylindrique du récipient (1), englobant ainsi une partie de la paroi latérale (45) du support sous-porteur (41), dans lequel la paroi latérale du couvercle (50) fait saillie perpendiculairement depuis une surface principale du couvercle S vers le sous-porteur,
o dans lequel une forme et une extension de la paroi latérale (50) du couvercle de support (42) et de la paroi latérale (45) du support sous-porteur (41) sont configurées pour former un autre canal d'écoulement de gaz (G) avec une partie de la paroi du volume interne.

2. Récipient (1) selon la revendication 1, dans lequel les ailettes (44) sont agencées pour former un canal d'écoulement de gaz en spirale (C) entre le premier orifice de plateau (46) dans une paroi latérale (45) du support sous-porteur (41) et le second orifice de plateau (47) dans le couvercle de support (42) .

3. Récipient (1) selon la revendication 1, dans lequel les ailettes (44) sont agencées pour former un canal d'écoulement de gaz méandrique (C) entre le premier orifice de plateau (46) dans une paroi latérale (45) du support sous-porteur (41) et le second orifice de plateau (47) dans le couvercle de support (42) ou au niveau d'une autre partie de la paroi latérale (45) du support sous-porteur (41).

4. Récipient (1) selon l'une quelconque des revendications 1 à 3, dans lequel le canal d'écoulement de gaz (C) est empêché de contourner l'écoulement à travers le plateau sous-porteur respectif (4) pour passer à travers le second orifice de plateau (47) jusqu'au plateau sous-porteur suivant (4) en haut.

5. Récipient (1) selon l'une quelconque des revendications 1 à 4, dans lequel le canal d'écoulement de gaz (C) dans chacun des plateaux sous-porteurs (4) est formé pour que le gaz porteur s'écoule à travers le récipient (1).

6. Récipient (1) selon l'une quelconque des revendications 1 à 5, dans lequel une structure d'écartement (48) est prévue au fond des plateaux sous-porteurs (4) pour permettre un écoulement de gaz porteur le long du fond des plateaux sous-porteurs (4) respectifs depuis/vers une partie d'une paroi interne de la partie de réception (12) du récipient (1) .

7. Récipient (1) selon l'une quelconque des revendications 1 à 6, dans lequel un élément chauffant (5) est fixé au récipient (1) pour chauffer le récipient (1) jusqu'à au moins une température d'évaporation du matériau précurseur.

8. Procédé pour délivrer un matériau précurseur vaporisé, le procédé comprenant
- la fourniture d'un récipient (1) selon l'une quelconque des revendications 1 à 7 avec un matériau précurseur ;
- la fourniture d'un gaz porteur au récipient et
- la réception du gaz porteur enrichi avec le matériau précurseur vaporisé ou le matériau précurseur vaporisé par tirage à la vapeur.

9. Procédé pour délivrer un matériau précurseur vaporisé selon la revendication 8, dans lequel le gaz porteur s'écoule le long du canal d'écoulement de gaz (C) avec un nombre de Reynolds inférieur à 2 000, de préférence inférieur à 5 000.

10. Procédé pour délivrer un matériau précurseur vaporisé selon la revendication 8 ou 9, dans lequel le matériau précurseur rempli dans le support de sous-porteur (41) est du type en vrac, tel qu'un matériau de type poudre, poudre frittée ou granulée.
